# EUROPÄISCHE PATENTSCHRIFT

(11) **EP 2 325 351 B1**
(45) Veröffentlichungstag und Bekanntmachung des Hinweises auf die Patenterteilung: **13.07.2016**
(21) Anmeldenummer: 10014541.6
(22) Anmeldetag: 12.11.2010
(51) Int. Cl.: C23C 16/02, C23C 16/455

(54) **Verfahren zur Beschichtung einer metallischen Substratoberfläche eines Werkstücks mit einer durch einen ALD-Prozess aufgebrachten Materialschicht**
Method for coating a metallic substrate surface of a workpiece with a material coating attached by means of an ALD process
Procédé de revêtement d'une surface de substrat métallique d'une pièce usinée dotée d'une couche de matériau appliquée selon un procédé ALD

(30) Priorität: 20.11.2009 DE 102009053889
(43) Veröffentlichungstag der Anmeldung: 25.05.2011
(73) Patentinhaber: C. Hafner GmbH + Co. KG, 71299 Wimsheim (DE)
(72) Erfinder: Duss, Martin, 71299 Wimsheim (DE); Schöttle, Marco, 71299 Wimsheim (DE); Schenzel, Heinz-Günter, Dr., 71299 Wimsheim (DE)
(74) Vertreter: Leitner, Waldemar

(56) Entgegenhaltungen:
- WO-A1-2007/088249
- DE-A1- 10 130 936
- US-A1- 2007 082 130
- US-A1- 2008 054 472
- US-B1- 6 897 119

## Beschreibung

Die Erfindung betrifft ein Verfahren und die Verwendung einer Vorrichtung zur Beschichtung einer metallischen Substratoberfläche mit einer durch einen ALD-Prozess aufgebrachten Materialschicht, wobei die zu beschichtende metallische Substratoberfläche vor dem Aufbringen der Materialschicht einer Plasma-Vorbehandlung unterzogen wird, wobei die Vorrichtung eine erste Prozesskammer und eine zweite Prozesskammer aufweist.

Die WO 2007/088249 beschreibt ein derartiges Verfahren, das aber auf SilberOberflächen beschränkt ist. Hierbei wird eine Schutzschicht mittels des ALD-Verfahrens unmittelbar auf die zu beschichtende Substratoberfläche aufgetragen.

Das aus der vorgenannten Druckschrift bekannte Verfahren besitzt den Nachteil, dass eine derartig beschichtete Silber-Oberfläche mit dem ALD-Prozess aufgebrachten Schutzschicht nur unzureichende Ergebnisse aufweist, was die Haftung dieser Schutzschicht auf der Silber-Oberfläche betrifft.

Die US 2007/0082130 A1 beschreibt ein Verfahren zur Herstellung einer metallischen Drahtstur, bei dem mittels eines ALD-Prozesses auf eine KupferOberfläche der metallischen Struktur eine Metallschicht aufgetragen wird. Vor der Durchführung des ALD-Prozesses wird eine Vorbehandlung durchgeführt. Deren erster Schritt dient dazu, das auf der Kupferoberfläche befindliche Oxid zu verringern. Hierzu wird die Drahtstruktur mit einer Gasmischung aus H₂ und He in einer Plasmakammer beaufschlagt. Im zweiten Schritt wird eine Nitrid-Sperrschicht auf-gebracht, indem dem in der Plasmakammer befindlichen Gas N₂ hinzugefügt wird.

Die US 2008/0054472 A1 beschreibt ein Verfahren zur Ablagerung eines dünnen Ruthenium-Films auf einem Substrat in einer Reaktionskammer. Bevor das Ruthenium mittels eines ALD-Prozesses abgeschieden wird, wird wiederum eine Vorbehandlung durchgeführt. Deren erster Schritt dient dann dazu, ein Oxid, das sich auf der Oberfläche des Kupfer-Werkstücks gebildet hat, zu entfernen. Im zweiten Schritt der Vorbehandlung wird eine Terminierung der derart vorbehandelten Oberfläche durchgeführt.

Die DE 101 30 936 A1 beschreibt ein Herstellungsverfahren für ein Halbleiterbauelement, wobei eine dielektrische Schicht durch ein ALD-Verfahren monolagenweise selbstlimitierend in Form von mindestens zwei verschiedenen Prekursoren alternierend abgeschieden wird. Vor Abscheiden der allerersten Monolage des ersten Prekursors wird eine Konditionierung der Oberfläche des Substrats bezüglich eines reaktiven Liganden des ersten Prekursors durchgeführt. Hierzu kann vorgesehen sein, dass das Werkstück mit einem gepulsten O₂-H2O-H₂-H2O-Plasma beaufschlagt wird, wobei Im ersten Schritt die O-Radikale der Sauerstoffbrückenbindung aufbrechen und so eine O-terminierte Oberfläche entsteht, wohingegen im zweiten Schritt die H-Redikale mit O zu OH-Gruppen reagieren. Eine Verwendung eines H₂-Plasmas ist ebenfalls möglich, wobei die H-Radikale dabei mögliche O-Brücken an der Substratoberfläche aufbrechen. Eine weitere Möglichkeit zur Konditionierung besteht in der Verwendung eines NH₃-Plasmas, das zur Nitritierung der Oberfläche des Substrats und zur Erzeugung einer H/H₂-Terminierung führt.

Vor dieser Konditionierung wird optimal eine Plasmareinigung unter Verwendung von NF₃, C12 oder ähnliches durchgeführt, um eine möglichst Siliziumoxid-freie Silizium-Oberfläche des Halbleitersubstrats zu erhalten.

Die US 6,637,119 B1 beschreibt eine Vorrichtung und ein Verfahren zur ALD-Abscheidung, bei dem die Oberfläche des Substrats einer Vorbehandlung unterzogen wird, um sie für die ALD-Abscheidung reaktiv zu machen. Hierzu ist vorgesehen, dass die Oberfläche des Substrats mit einem Sauerstoff-Plasma beaufschlagt wird.

Es ist daher Aufgabe der vorliegenden Erfindung, ein Verfahren der eingangs genannten Art derart weiterzubilden, dass eine verbesserte Haftung einer Materialschicht auf der zu beschichtenden metallischen Substratoberfläche gegeben ist, zu schaffen, sowie die Verwendung einer zur Durchführung des Verfahrens besonders geeigneten Vorrichtung.

Diese Aufgabe wird durch das erfindungsgemäße Verfahren dadurch gelöst, dass als Plasma-Vorbehandlung eine mindestens zweistufige Plasma-Vorbehandlung verwendet wird, wobei in einer ersten Stufe der mindestens zweistufigen Plasma-Vorbehandlung eine Reduktion der Substratoberfläche mit einem reduzierenden Plasma zur Reinigung der Substratoberfläche von organischem Material und anschließend in einer zweiten Stufe eine Oxidation der zu beschichtenden Substratoberfläche mit einem oxidierenden Plasma zur Ausbildung einer stabilen OxidSchicht, auf der die durch den nachfolgenden ALD-Prozess abzuscheidende Materialschicht ankoppeln kann, durchgeführt wird.

Erfindungsgemäß ist bei der verwendeten Vorrichtung vorgesehen, dass die erste Prozesskammer der Vorrichtung als eine Plasma-Kammer ausgebildet ist, in der eine zweistufige Plasma-Vorbehandlung durchgeführt wird, wobei in der ersten Prozesskammer die Substratoberfläche des in ihr befindlichen Werkstücks zu ihrer Reinigung von organischem Material mit einem reduzierenden Plasma und daran anschließend mit einem oxidierenden Plasma zur Ausbildung einer Oxid-Schicht beaufschlagt wird, und dass die zweite Prozesskammer als eine ALD-Prozesskammer ausgebildet ist, in der eine ALD-Beschichtung des in der ersten Prozesskammer vorbehandelten Werkstücks durchgeführt wird.

Die erfindungsgemäßen Maßnahmen besitzen den Vorteil, dass die Haftung der Materialschicht, insbesondere einer Schutzschicht, auf der wie vorstehend beschrieben mit einer mindestens zweistufigen Plasma-Vorbehandlung behandelten Substratoberfläche deutlich verbessert wird. Ein weiterer Vorteil des erfindungsgemäßen Verfahrens besteht darin, dass mit ihm nicht nur - wie bei dem eingangs zitierten Verfahren - Silberoberflächen, sondern auch andere metallische Substratoberflächen, auch als galvanisch beschichtete Oberflächen, beschichtet werden können.
Eine vorteilhafte Weiterbildung der Erfindung sieht vor, dass im ersten Schritt der zweistufigen Plasma-Vorbehandlung ein Kohlenstoff-Plasma verwendet wird. Eine derartige Vorbehandlung mit einem Kohlenstoff-Plasma ist insbesondere dann von Vorteil, wenn - wie gemäß der Erfindung vorgesehen ist - in dem darauf folgenden zweiten Schritt der mindestens zweistufigen Plasma-Vorbehandlung die Substrat-Oberfläche mit einem Sauerstoff-Plasma beaufschlagt wird.

Eine weitere vorteilhafte Weiterbildung der Erfindung sieht vor, dass nach der Vorbehandlung der metallischen Substratoberfläche und vor dem Aufbringen der Materialschicht durch den ALD-Prozess die metallische Substratoberfläche mit einem oxidationsverstärkenden Plasma beaufschlagt wird. Eine derartige Maßnahme besitzt den Vorteil, dass hierdurch die Haftung, insbesondere bei einer metallischen Substratoberfläche aus Palladium oder Gold, noch weiter verbessert wird. Vorzugsweise ist hierbei vorgesehen, dass als oxidationsverstärkendes Medium ein Chlor-Plasma verwendet wird.

Eine weitere vorteilhafte Weiterbildung der Erfindung sieht vor, dass die Plasma-Vorbehandlung mit einem Niedrigdruckverfahren durchgeführt wird, wobei typischerweise ein Prozessdruck von 0,15 bis 0,50 mbar verwendet werden. Hierdurch wird in vorteilhafter Art und Weise kein Anätzen der Substratoberfläche, sondern eine Reinigung derselben erreicht.

Eine vorteilhafte Weiterbildung der erfindungsgemäßen Verwendung der Vorrichtung sieht vor, dass in die erste Prozesskammer mindestens eine Leitung mündet, über die der ersten Prozesskammer zur Herstellung eines reaktiven Mediums dienende Prozessgase zugeführt sind, und dass der zweiten Prozesskammer über Leitungen die für den ALD-Prozess erforderlichen Precursoren sowie über eine weitere Leitung ein Trägergas zugeführt sind.

Weitere vorteilhafte Weiterbildungen der Erfindung sind Gegenstand der Unteransprüche.

Weitere Einzelheiten und Vorteile der Erfindung sind den Ausführungsbeispielen zu entnehmen, die im folgenden beschrieben werden. Es zeigen:

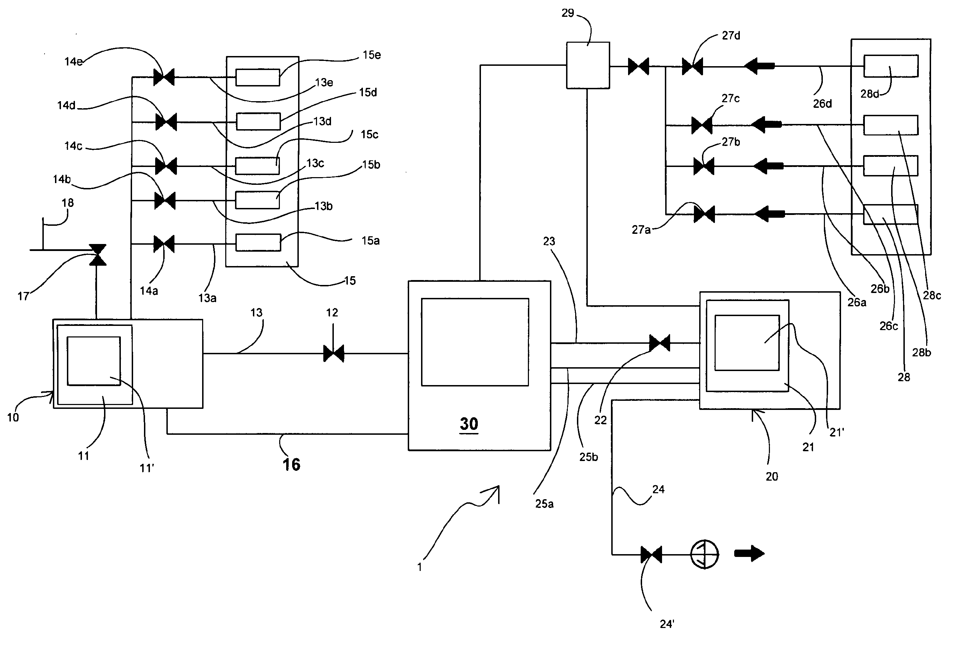

- Figur 1:: eine schematische Darstellung einer Vorrichtung zur Durchführung des Verfahrens.

Das erste Ausführungsbeispiel betrifft die Beschichtung eines Substrats aus galvanischem Silber mit einer 100 nm dicken Materialschicht aus Al₂O₃, wobei diese Materialschicht mittels eines Atomic Layer Deposition (ALD)-Prozesses auf die Substratoberfläche aufgebracht werden soll. Die Beschichtung einer Substratoberfläche mittels eines ALD-Prozesses ist bekannt und wird daher nachfolgend nur äußerst kurz beschrieben.

Vor dem Auftrag der Al₂O₃-Materialschicht auf die Substratoberfläche wird diese einer zweistufigen Plasma-Vorbehandlung unterzogen, wobei der erste Vorbehandlungsschritt dazu dient, die Substratoberfläche von organischem Material wie z. B. Kohlenwasserstoffen zu reinigen. Hierzu wird das Substrat in eine Plasmakammer eingebracht und dort mit einem reduzierenden Medium, das sich in einem plasmaförmigen Zustand befindet, beaufschlagt. Als reduzierendes Medium wird hier ein Kohlenstoff-Plasma eingesetzt. Es ist aber auch möglich, Wasserstoff-Plasma, Kohlensäure-Plasma, Kohlenwasserstoff-Plasma und Argon-Plasma, um nur einige reduzierende Medien zu nennen, zu verwenden. In der Plasmakammer wird hierzu aus Kohlenstoff oder einem kohlenstoffhaltigen Material das Kohlenstoff-Plasma erzeugt, und die Substratoberfläche wird dann zwischen 35 und 120 Sekunden mit dem Kohlenstoff-Plasma beaufschlagt, wobei dieser erste Vorbehandlungsschritt vorzugsweise bei einem Druck von ungefähr 0,15 bis 0,50 mbar, vorzugsweise bei 0,25 mbar, bei Raumtemperatur durchgeführt wird. Dabei wird die Plasmakammer vorzugsweise mit einer relativ niedrigen Leistung betrieben, um kein Anätzen der Substratoberfläche, sondern nur deren Reinigung von organischem Material zu bewirken. Typischerweise beträgt die Leistung der Plasmakammer 0,1 kWh, bezogen auf ein Kammervolumen von 10 I. Die Beaufschlagung der Substratoberfläche mit dem reduzierenden Plasma dauert zwischen 2,6 und 3,5 Minuten, wobei eine Behandlungsdauer von ca. 3 Minuten bevorzugt wird.

Nach dem Entfernen des in der Plasmakammer befindlichen Kohlenstoff-Plasmas, z. B. durch Abpumpen, wird dann die derart reduzierte Substratoberfläche mit einem oxidierenden Plasma beaufschlagt. Anstelle von Sauerstoff-Plasma kann auf ein anderes oxidierendes Plasma, z. B. ein Ozon-Plasma oder ein Chlor-Plasma, eingesetzt werden. Im beschrieben Fall wird Sauerstoff zur Bildung eines Sauerstoff-Plasmas verwendet, wobei der Plasmakammer ein Sauerstoffvolumenstrom von ungefähr 40 - 60 cm³/min zugeführt wird. Der Prozessdruck in der Plasmakammer beträgt wiederum zwischen 0,15 und 0,50 mbar und die zweite Stufe der Plasma-Vorbehandlung wird während einer Zeitspanne von 0,6 bis 1,5 Minuten, vorzugsweise von ungefähr 1 Minute, bei Raumtemperatur durchgeführt.

Durch die Oxidation der Substratoberfläche wird erreicht, dass auf der Substratoberfläche eine stabile Oxid-Schicht ausgebildet wird, an der dann die durch den ALD-Prozess aufzubringende Materialschicht ankoppeln kann. Im beschriebenen Fall koppelt das Al des durch den ALD-Prozess aufgebrachten Al₂O₃ an einem Sauerstoff-Atom oder -Ion an, wobei eine gute Haftung der durch den ALD-Prozess aufgebrachten Al₂O₃-Schicht auf dem die Substratoberfläche ausbildenden galvanischen Silber bewirkt wird.

Nach dieser Plasma-Vorbehandlung wird dann der eigentliche ALD-Prozess durchgeführt: Hierzu wird das Substrat in eine entsprechende Prozesskammer eingebracht. Es ist aber bei einer entsprechende Ausbildung der hierzu verwendeten Anlage auch möglich, die ALD-Beschichtung in der zur Plasmabeaufschlagung verwendeten Kammer durchzuführen. Zur ALD-Beschichtung wird dann das Substrat auf die Betriebstemperatur der an und für sich bekannten und daher nicht mehr näher beschriebenen ALD-Beschichtungsanlage gebracht. Eine Betriebstemperatur von 80 bis 120 Grad Celsius wird bevorzugt, wobei in diesem Temperaturbereich eine Temperatur von ca. 100° bevorzugt wird. Nachdem die ALD-Beschichtung aufgebracht wurde, wird das Substrat aus der Prozesskammer entnommen, wobei vorzugsweise diese nicht vorher abgekühlt wird, so dass das Substrat bei Raumtemperatur abkühlt.

Die Haftung der durch den ALD-Prozess aufgebrachten Materialschicht auf dem Substrat wurde dann gemäß DIN EN ISO 2409 durchgeführt, wobei in jede Richtung der beschichteten Substratoberfläche sechs Schnitte gesetzt wurden. Das darauf fest angedrückte Klebeband wird unter einem Winkel von ca. 60° ruckartig schnell abgerissen, wobei bei dem beschriebenen Ausführungsbeispiel als Klebeband ein Klebeband der Firma Bayersdorf AG mit der Bezeichnung "Tesa" Nr. 4129 verwendet wird. Die Einstufung der dadurch verursachten Oberflächeneffekte wird nach ISO 2409 in Stufen "0" bis "5" vorgenommen, wobei "0" eine unversehrte und "5" eine zu mehr als 65 %ige Zerstörung der Oberfläche bezeichnet.

Ein Vergleich der Haftung der Materialschicht auf dem wie vorstehend beschriebenen behandelten Substrat aus galvanischem Silber mit einem unbehandelten Substrat, bei dem der ALD-Prozess unter den gleichen Prozessparametern durchgeführt wurde, zeigt, dass eine deutlich verbesserte Haftung der Al₂O₃-Schicht auf dem galvanischen Silber gegeben ist: Bei der auf die vorbehandelte Substratoberfläche aus galvanischem Silber aufgetragene Materialschicht aus Al₂O₃ wurde jeweils eine sehr gute Haftung (entspricht der Note "O") erzielt, während bei einer nicht-vorbehandelten Substratoberfläche durchwegs die Stufe "5" gegeben war, d. h., der Klebeband-Test resultierte in einer mehr als 65 %igen Zerstörung der Oberfläche.

Beim zweiten Ausführungsbeispiel wird eine Schicht aus TiO₂ in einer Dicke von 50 nm auf die metallische Substratoberfläche, die wiederum galvanisiertes Silber ist, aufgetragen. Der Verfahrensablauf sowie die Prozessparameter entsprechen denen des ersten Ausführungsbeispiels. Auch hier ist wiederum zu vermerken, dass die Haftung der durch den ALD-Prozess auf die wie vorstehend beschrieben behandelte Substratoberfläche aufgetragenen TiO₂-Schicht durchwegs der Stufe "0" des vorgenannten Klebeband-Tests zuzuordnen ist, während bei einer nicht-vorbehandelten Substratoberfläche der Klebeband-Test eine Oberflächenbeschädigung von mehr als 65 % verursacht hätte, also die Stufe "5" vorliegt.

Beim dritten Ausführungsbeispiel wird galvanisches Gold mit einer durch ein ALD-Verfahren aufgetragenen Al₂O₃-Schicht beschichtet. Die Verfahrensparameter der zweistufigen Plasma-Vorbhandlung sowie diejenigen der ALD-Beschichtung entsprechen den beim ersten Ausführungsbeispiel erläuterten. Als Ergebnis ist festzuhalten, dass auch bei einer Substratsoberfläche aus galvanischem Gold eine deutlich verbesserte Haftung dieser Al₂O₃-Schicht erzielt wurde, als dies bei einem unbehandelten Substrat der Fall war: Die Haftung der Al₂O₃-Schicht auf dem vorbehandelten galvanischem Gold ist durchwegs der Stufe "0" zuzuordnen, während die Haftung dieser Schicht auf einem nicht-vorbehandelten Substrat aus galvanischem Gold der Stufe "5" zuzuordnen ist.

Das vierte Ausführungsbeispiel betrifft die ALD-Beschichtung einer Substratoberfläche aus galvanischem Palladium mit einer Al₂O₃-Schicht. Zur Durchführung der Plasma-Vorbehandlung sowie der ALD-Beschichtung wurden wiederum die Prozessparameter des ersten Ausführungsbeispiels eingehalten. Auch hier zeigte sich wiederum eine eindeutige Verbesserung der Haftung der auf das galvanische Palladium aufgebrachten Schicht aus Al₂O₃ und TiO₂. Während bei einer unbehandelten Substratoberfläche aus galvanischem Palladium die Haftung der aufgebrachten Materialschicht der Stufe "3" oder "4" zuzuordnen war, wurde bei einer Plasma-Vorbehandlung eine Haftung der Materialschicht auf der Substratoberfläche erzielt, die der Stufe "0" zuzuordnen war.

Die Anmelderin führte dann weitere Versuche durch, wobei Substratoberflächen aus galvanisch aufgebrachtem Platin, galvanisch aufgebrachtem Rhodium, galvanisch aufgebrachtem Ruthenium, also galvanisch aufgebrachten Edelmetallen, die wie oben beschrieben einer zweistufigen Plasma-Vorbehandlung unterzogen und danach mit einem ALD-Verfahren mit Al₂O3 oder TiO₂ behandelt wurden. Auch hierbei zeigte sich eine deutliche Verbesserung der Haftung der auf die vorgenannten Substratoberflächen aufgebrachten ALD-Schicht, als dies bei unbehandelten Substratoberflächen der Fall war.

Weitere Versuche wurden an metallischen Substratoberflächen aus Edelmetall, wie z. B. Silber, Gold, Palladium und Platin durchgeführt. Auch hier war wiederum eine deutliche Verbesserung der Haftung der Materialschicht auf der mittels der zweistufigen Plasma-Vorbehandlung behandelten Substratoberfläche zu beobachten.

Des weiteren wurden Versuche mit metallischen Substratoberflächen aus Nicht-Edelmetallen, wie z. B. Kupfer, Messing, Edelstähle und Stähle allgemein und galvanischen Oberflächen aus Nicht-Edelmetallen, wie z. B. Nickel, Bronze und Kupfer durchgeführt. Auch hier wurde wiederum eine deutliche Verbesserung der Haftung der auf das Substrat aufgetragenen ALD-Schicht beobachtet.

Optional kann bei dem beschriebenen Verfahren vorgesehen sein, dass nach der vorstehend beschriebenen zweistufigen Plasma-Vorbehandlung noch weitere Plasma-Vorbehandlungsstufen durchgeführt werden. Vorzugsweise wird hierbei in einer dritten Stufe der dann dreistufigen Plasma-Vorbehandlung ein oxidationsverstärkendes Plasma, wie z. B. ein Chlor-Plasma, verwendet. Die Verwendung eines Chlor-Plasmas besitzt insbesondere bei metallischen Substratoberflächen aus Palladium oder Gold den Vorteil, dass damit noch eine weitere Haftungsverbesserung der mittels des ALD-Prozesses aufgetragenen Materialschicht erzielt werden kann.

Zur Durchführung dieses Verfahrens eignet sich nun insbesondere die in Figur 1 dargestellte Vorrichtung 1. Diese weist eine erste Prozesskammer 10 und eine zweite Prozesskammer 20 auf. Die erste Prozesskammer 10 ist die vorstehend beschriebene Plasmakammer, in der die Vorbehandlung des zu beschichtenden Werkstücks mit der verfahrensgemäßen, zweistufigen Plasma-Vorbehandlung durchgeführt wird. Die zweite Prozesskammer 20 ist die vorstehend beschriebene ALD-Prozesskammer, in der der eigentliche ALD-Prozess durchgeführt wird. Jede der beiden Kammern 10, 20 verfügt über eine luftdicht zu verschließende Tür 11 bzw.21 mit einem Sichtfenster 11' bzw. 21', durch die das oder die zu behandelnden Werkstücke in die jeweilige Prozesskammer 10 bzw. 20 einbringbar ist oder sind.

Der einfachen Beschreibung halber wird im folgenden davon ausgegangen, dass in den Prozesskammern 10 und 20 nur ein Werkstück vorhanden ist. Dem Fachmann ist aber ersichtlich, dass die beschriebene Vorrichtung 1 natürlich auch zur gleichzeitigen Behandlung von mehreren Werkstücken, was der Regelfall sein wird, geeignet ist.

Die beiden Prozesskammern 10, 20 sind über eine durch ein Ventil 12 bzw. 22 verschließbare Leitung 13 bzw. 23 mit einer nicht näher dargestellten Vakuumeinrichtung verbunden. Die Vakuumeinrichtung dient dazu, in den Prozesskammern 10, 20 ein Vakuum mit den vorstehend beschriebenen Werten zu erzeugen.

Die erste Prozesskammer 10 weist einen in der Figur 1 nicht gezeigten, an und für sich bekannten und daher nicht mehr näher beschriebenen Plasmagenerator auf, welcher dazu dient, das zur zweistufigen Plasma-Vorbehandlung der Substratoberfläche des Werkstücks erforderliche Plasma zu erzeugen, wobei der Plasmagenerator - wie vorstehend beschrieben - typischerweise eine Leistung von 0,1 kWh, bezogen auf ein Kammervolumen von 10 Liter, hat. Die erste Prozesskammer 10 besteht vorzugsweise aus Titan oder einem Gussmaterial mit einer Edelstahllochgitteranordnung für den Betrieb mit dem Plasmagenerator.

Um nun der ersten Prozesskammer 10 die vorstehend beschriebenen Prozessgase zur Erzeugung des sich bei der Vorbehandlung in einem plasmaförmigen Zustand befindenden reduzierenden bzw. oxidierenden Mediums zuzuführen, sind eine entsprechende Anzahl von Gasleitungen 13a-13e vorgesehen, welche in die erste Prozesskammer 10 münden und über Ventile 14a-14e absperrbar sind. In dem hier beschriebenen Fall sind als Reaktanten Kohlenstoff, Wasserstoff oder Argon (reduzierend) sowie Sauerstoff oder Chlor (oxidierend) vorgesehen, wobei aber dem Fachmann klar ersichtlich ist, dass diese vorgenannten Gase nur exemplarisch erwähnt sind. Wie vorstehend auf Seite 4 beschrieben, ist es auch möglich, andere reduzierende bzw. oxidierende Medien zu verwenden. Die vorgenannten Medien sind in Vorratsbehältern 15a-15e einer Gasspeichereinheit 15 gespeichert, in welche die Gasleitungen 13a-13e münden.

Es ist aber auch möglich, dass anstatt der ersten Prozesskammer 10 ein Prozessgas, z. B. ein Kohlenstoffgas, zuzuführen, in diese ein entsprechendes festes z. B. ein kohlenstoffhaltiges Medium, einzubringen, aus dem dann das Prozessgas, z. B. ein Kohlenstoff-Plasma, erzeugt wird. Nachfolgend soll jedoch davon ausgegangen werden, dass die zur Erzeugung eines reduzierenden bzw. oxidierenden Plasmas erforderlichen Ausgangsstoffe der Prozesskammer 10 in gasförmiger Form, also als Prozessgase, zugeführt werden. Dem Fachmann ist klar ersichtlich, welche Modifikationen er vorzunehmen hat, wenn er anstelle von gasförmigen Reaktanten entsprechende feste Stoffe zur Erzeugung des reduzierenden bzw. oxidierenden Plasmas der Prozesskammer 10 zuführt.

Bei der nachfolgenden Beschreibung wird davon ausgegangen, dass in dem ersten Vorratsbehälter 15a Argon, im zweiten Vorratsbehälter 15b Wasserstoff, im dritten Vorratsbehälter 15c Sauerstoff, im vierten Vorratsbehälter 15d Kohlenstoff und im fünften Vorratsbehälter 15e Chlor, jeweils in Gasform, gespeichert sind.

Die erste Prozesskammer 10 ist über eine Signalleitung 16 mit einer Regel- und Überwachungseinheit 30 verbunden, so dass von dieser erzeugte Signale zu der ersten Prozesskammer 10 geleitet werden. Die Regel- und Überwachungseinheit 30 regelt und überwacht insbesondere den Prozessdruck in der ersten Prozesskammer 10, die Menge des oder der ersten Prozesskammer 10 zugeführten reaktiven Prozessgase und das in dieser herrschende Vakuum.

Nachdem ein oder mehrere der vorstehend beschriebenen Reaktanten-Gase der ersten Prozesskammer 10 zugeführt und ein reduzierendes Plasma daraus erzeugt wurde, regelt und überwacht die Regel- und Überwachungseinheit 30 die einzustellenden Parameter, wie sie bei dem vorstehend beschriebenen Verfahren erläutert sind. Das in der ersten Prozesskammer 10 aufgenommene Werkstück wird dann wie vorstehend beschrieben mit der ersten Stufe der verfahrensgemäßen zweistufigen Plasma-Vorbehandlung behandelt. Nach Abschluss dieser ersten Vorbehandlungsstufe wird die erste Prozesskammer 10 über eine durch ein Ventil 17 absperrbare Abluftleitung 18 entleert.

Die wie vorstehend beschrieben reduzierte Substratoberfläche des Werkstücks W wird dann im zweiten Schritt der Plasma-Vorbehandlung mit einem oxidierenden Plasma beaufschlagt. Wie vorstehend beschrieben, wird bei dem beschriebenen Ausführungsbeispiel ein Sauerstoff-Plasma eingesetzt. Durch die Regel- und Überwachungseinheit 30 kontrolliert wird der ersten Plasmakammer 10 über die dritte Leitung 13c ein Sauerstoffvolumenstrom von ungefähr 40-60 cm³/min zugeführt und ein Prozessdruck von zwischen 0,15 und 0,5 mbar eingestellt, wobei diese zweite Stufe der Plasma-Vorbehandlung - wie bereits vorstehend beschrieben - ungefähr 0,6 bis 1,5 Minuten dauert. Nach Abschluss dieser zweiten Stufe der Plasma-Vorbehandlung wird die erste Prozesskammer 10 wiederum durch die Abluftleitung 18 entleert, so dass das in der ersten Prozesskammer 10 befindliche Werkstück aus dieser entnommen werden und zur zweiten Prozesskammer 20 gebracht werden kann.

Die zweite Prozesskammer 20 besteht vorzugsweise aus einem Edelstahlgehäuse mit einer Titanreaktionskammer als Prozessraum für die Beschichtung des wie vorstehend beschrieben zweistufig plasmavorbehandelten metallischen Substrats des Werkstücks. Der Prozessraum der zweiten Prozesskammer 20 ist über die Leitung 23 an die Vakuumeinheit angeschlossen. Zusätzlich verfügt die zweite Prozesskammer 20 über eine Entlüftungsleitung 24, die von einem Ventil 24' öffen- und schließbar ist. Diese dient dazu, die zweite Prozesskammer 20 nach der Durchführung des bereits vorstehend beschriebenen Verfahrensschritts zu entlüften und die beim Behandlungsprozess entstehenden Abbauprodukte abzuführen.

Im Gegensatz zur ersten Prozesskammer 10, bei der die zweistufige Plasma-Vorbehandlung vorzugsweise bei Raumtemperatur durchgeführt wird, verfügt die zweite Prozesskammer 20 über eine bekannte und daher nicht dargestellte Heizung, die über eine Signalleitung 25a von der Regel- und Überwachungseinheit 30 geregelt und überwacht wird. Über eine weitere Signalleitung 25b ist die zweite Prozesskammer 20 mit der Regel- und Überwachungseinheit 30 verbunden.

Der zweiten Prozesskammer 20 werden über Leitungen 26a-26c die zur Beschichtung des zweitstufig plasmavorbehandelten Werkstücks erforderlichen Precursoren und über eine Leitung 26d Stickstoff als Trägergas zugeführt. Die Leitungen 26a-26d sind hierbei durch Ventile 27a-27d öffen- und schließbar. Im hier beschriebenen Beispiel werden über die Gasleitung 26a Trimethylaluminium TMA, über die Leitung 26b Wasser H₂O und über die Leitung 26c Titanchlorid TiCl zugeführt. Die vorgenannten Gase sind in Vorratsbehältern 28a-28d einer Gasspeichereinrichtung 28 gespeichert.

Vorzugsweise ist vorgesehen, dass die einzelnen Gase dem Prozessraum der zweiten Prozesskammer 10 nicht unmittelbar, sondern über einen Ansaugstutzen 29, welcher vorzugsweise aus Edelstahl oder Glas ausgebildet ist, zugeführt werden. Die Leitungen 26a-26d münden in diesen Ansaugstutzen 29.

Die bereits vorstehend bei der Beschreibung des Verfahrens erläuterten Prozessparameter zur ALD-Beschichtung des in der zweiten Prozesskammer 20 aufgenommenen Werkstücks werden wieder durch die Regel- und Überwachungseinheit 30 geregelt und überwacht. Diese regelt und überwacht mit insbesondere den Prozessdruck, die Menge der der Prozesskammer 20 zugeführten Prozessgase und das in ihr herrschende Vakuum sowie die Dauer des Beschichtungsprozesses und auch die Temperatur, mit der dieser Prozess durchgeführt wird. Vorzugsweise wird hier eine Reaktionstemperatur von 100 C vorgesehen und die Temperatur des Precursors Wassers beträgt ungefähr 30 °C, diejenige des Precursors Trimethylaluminium ungefähr 25 °C, die Temperatur des Precursors Titanchlorid 25 °C und die Precursor-Leitungen 26a-26c werden auf einer Temperatur von ungefähr 85 °C gehalten, wobei die zweite Prozesskammer 20 auf einen Prozessdruck von ungefähr 2 mbar gehalten wird.

Nach der Durchführung des Beschichtungsprozesses wird dann die zweite Prozesskammer 20 wieder entlüftet und das Werkstück wird aus dieser entnommen.

Zusammenfassend ist festzuhalten, dass das beschriebene Verfahren und die vorgestellte Vorrichtung es in vorteilhafter Art und Weise erlauben, metallische Substratoberflächen aus Edelmetallen und Nicht-Edelmetallen sowie galvanischen Edelmetallen und galvanischen Nicht-Edelmetallen mit einer ALD-Schicht zu beschichten, wobei ein deutlich verbessertes Haftvermögen dieser Materialschichten auf der Substratoberfläche erzielt wird. Das Verfahren und die Vorrichtung eignen sich daher insbesondere zur Aufbringung von dauerhaft anhaftenden Schutzschichten auf metallische Substratoberflächen.

## Patentansprüche

1. Verfahren zur Beschichtung einer metallischen Substratoberfläche mit einer durch einen ALD-Prozess aufgebrachten Materialschicht, wobei die zu beschichtende metallische Substratoberfläche vor dem Aufbringen der Materialschicht einer Plasma-Vorbehandlung unterzogen wird, **dadurch gekennzeichnet, dass** als Plasma-Vorbehandlung eine mindestens zweistufige Plasma-Vorbehandlung verwendet wird, wobei in einer ersten Stufe der mindestens zweistufigen Plasma-Vorbehandlung eine Reduktion der Substratoberfläche mit einem reduzierenden Plasma zur Reinigung der Substratoberfläche von organischem Material und anschließend in einer zweiten Stufe eine Oxidation der zu beschichtenden Substratoberfläche mit einem oxidierenden Plasma zur Ausbildung einer stabilen Oxid-Schicht, auf der die durch den nachfolgenden ALD-Prozess abzuschneidende Materialschicht ankoppeln kann, durchgeführt wird.

2. Verfahren nach Anspruch 1, **dadurch gekennzeichnet, dass** als reduzierendes Medium ein Kohlenstoff-Plasma, ein Wasserstoff-Plasma, ein Kohlensäure-Plasma, ein Kohlenwasserstoff-Plasma oder ein Argon-Plasma verwendet wird.

3. Verfahren nach Anspruch 1, **dadurch gekennzeichnet, dass** als oxidierendes Medium ein Sauerstoff-Plasma, ein Ozon-Plasma oder ein Chlor-Plasma verwendet wird.

4. Verfahren nach einem der vorangehenden Ansprüche, **dadurch gekennzeichnet, dass** nach den zwei Stufen der Plasma-Vorbehandlung der metallischen Substratoberfläche mit einem reduzierenden Plasma und einem oxidierenden Plasma in einer dritte Stufe der Plasma-Vorbehandlung eine Beaufschlagung der metallischen Substratoberfläche mit einem oxidationsverstärkendem Plasma, insbesondere einem Chlor-Plasma, durchgeführt wird.

5. Verfahren nach einem der vorangehenden Ansprüche, **dadurch gekennzeichnet, dass** die Plasma-Vorbehandlung in einem Niederdruckverfahren durchgeführt wird, wobei vorzugsweise ein Druck von 0,15 bis 0,50 mbar, vorzugsweise 0,25 mbar, verwendet wird.

6. Verfahren nach einem der vorangehenden Ansprüche, **dadurch gekennzeichnet, dass** die Plasma-Vorbehandlung bei Raumtemperatur durchgeführt wird.

7. Verfahren nach einem der vorangehenden Ansprüche, **dadurch gekennzeichnet, dass** zur ALD-Beschichtung die Substratoberfläche auf eine Temperatur zwischen 80° und 120°, vorzugsweise auf ca. 100°. erwärmt wird.

8. Verfahren nach einem der vorangehenden Ansprüche, **dadurch gekennzeichnet, dass** die Behandlung der metallischen Substratoberfläche mit dem reduzierenden Plasma während eines Zeitraums zwischen 2,6 und 3,5 min, vorzugsweise ungefähr 3 min, durchgeführt wird.

9. Verfahren nach einem der vorangehenden Ansprüche, **dadurch gekennzeichnet, dass** die Behandlung der metallischen Substratoberfläche mit dem oxidierenden Plasma und/oder dem oxidationsverstärkendem Plasma während eines Zeitraums von 0,6 bis 1,5 min, vorzugsweise ungefähr 1 min, durchgeführt wird.

10. Verwendung einer Vorrichtung zur Beschichtung einer metallischen Substratoberfläche eines Werkstücks mit einer durch einer ALD-Prozess aufgebrachten Materialschicht, wobei die Vorrichtung eine erste Prozesskammer (10) und eine zweite Prozesskammer (20) aufweist, **dadurch gekennzeichnet, dass** die erste Prozesskammer (10) als eine Plasma-Kammer ausgebildet ist, in der eine zweistufige Plasma-Vorbehandlung durchgeführt wird, wobei in der ersten Prozesskammer (10) die Substratoberfläche des in ihr befindlichen Werkstücks zu ihrer Reinigung von organischem Material mit einem reduzierenden Plasma und daran anschließend mit einem oxidierenden Plasma zur Ausbildung einer Oxid-Schicht beaufschlagt wird, und dass die zweite Prozesskammer (20) als eine ALD- Prozesskammer ausgebildet ist, in der eine ALD-Beschichtung des in der ersten Prozesskammer (10) vorbehandelten Werkstücks durchgeführt wird.

11. Verwendung einer Vorrichtung nach Anspruch 10, **dadurch gekennzeichnet, dass** in die erste Prozesskammer (10) mindestens eine Leitung (13a-13e) mündet, über die der ersten Prozesskammer (10) zur Herstellung eines reaktiven Mediums dienende Prozessgase zugeführt sind, und dass der zweiten Prozesskammer (20) über Leitungen (26a-26c) die für den ALD-Prozess erforderlichen Precursoren sowie über eine weitere Leitung (26d) ein Trägergas zugeführt sind.

12. Verwendung einer Vorrichtung nach Anspruch 10, **dadurch gekennzeichnet, *dass*** in der ersten Prozesskammer (10) Wasserstoff, Kohlensäure, Kohlenwasserstoff und/oder Argon sowie Sauerstoff, Ozon und/oder Chlor vorhanden ist.

13. Verwendung einer Vorrichtung nach einem der vorangehenden Ansprüche, **dadurch gekennzeichnet, dass** in der zweiten Prozesskammer (20) Wasser, Trimethylaluminium oder Titan vorhanden ist, wobei die Temperatur des Wassers ungefähr 30 °C, die des zugeführten Trimethylaluminiums ungefähr 25 °C, die des zugeführten Titanchlorids ungefähr 25 °C beträgt.

14. Verwendung einer Vorrichtung nach einem der Ansprüche 10 bis 13, **dadurch gekennzeichnet, dass** eine Regel- und Überwachungseinheit (30) der Vorrichtung (1) den in den Prozesskammern (10, 20) herrschenden Prozessdruck auf ungefähr 0,15 bis 0,50 mbar, vorzugsweise 0,25 mbar, regelt.

15. Verwendung einer Vorrichtung nach einem der Ansprüche 10 bis 14, **dadurch gekennzeichnet, dass** die zweite Prozesskammer (20) eine Heizeinrichtung aufweist.

16. Verwendung einer Vorrichtung nach einem der vorangehenden Ansprüche, **dadurch gekennzeichnet, dass** die erste Prozesskammer (10) und/oder die zweite Prozesskammer (20) eine Entlüftungsleitung (18 bzw. 24) aufweist.

## Claims

1. Method for coating a metallic substrate surface with a material coating applied by means of an ALD-process, in which the metallic substrate surface to be coated is subjected to a plasma-pretreatment before applying the material coating, **characterized in that** a plasma-pretreatment comprising at least two-steps is used as the plasma-pretreatment, that in a first step of the at least two-step plasma-pretreatment a reduction of the substrate surface with a reducing plasma for cleaning the substrate surface of organic material and subsequently in a second step an oxidation of the substrate surface to be coated with a oxidizing plasma for creating a stabile oxide-coating, with which the material coating to be applied by the consecutive ALD-process can couple, is performed.

2. Method according to claim 1, **characterized in that** a carbon-plasma, a hydrogen-plasma, a carbonic-acid-plasma or an argon-plasma is used as a reducing media.

3. Method according to claim 1, **characterized in that** an oxygen plasma, an ozone-plasma or a chlorine-plasma is used as an oxidizing medium.

4. Method according to one of the previous claims, **characterized in that** after the two steps of the plasma-pretreatment of the metallic substrate surface with a reducing plasma and an oxidizing plasma in a third step of the plasma-pretreatment an impacting of the metallic substrate surface with an oxidation enhancing plasma, in particular a chlorine-plasma, is performed.

5. Method according to one of the previous claims, **characterized in that** the plasma-pretreatment is performed with a low pressure method, wherein in particular a pressure of 0,15 to 0,50 mbar, preferably 0,25 mbar, is used.

6. Method according to one of the previous claims, **characterized in that** the plasma-pretreatment is performed at ambient temperature.

7. Method according to one of the previous claims, **characterized in that** for the ALD-coating the substrate surface is heated up to a temperature between 80° and 120°, preferably approximately 100°.

8. Method according to one of the previous claims, **characterized in that** the treatment of the metallic substrate surface with the reducing plasma is performed within a time period between 2,6 and 3,5 min, preferably approximately 3 min.

9. Method according to one of the previous claims, **characterized in that** the treatment of the metallic substrate surface with an oxidizing plasma and/or the oxidation enhancing plasma is performed within a time period between 0,5 and 1,5 min, preferably approximately 1 min.

10. Use of a device for coating a metallic substrate surface of a work piece with a coating applied by an ALD-process, the device having a first process chamber (10) and a second process chamber (20), **characterized in that** the first process chamber (10) is a plasma chamber, in which the two-step plasma-pretreatment is performed, wherein in the first process chamber (10) the substrate surface of the work piece contained in it, is, for cleaning it of organic material, treated with a reducing plasma and consecutively with an oxidizing plasma for generating an oxide-coating, and that the second process chamber (20) is an ALD-process chamber, in which an ALD-coating of the work piece pre-treated in the first process chamber (10) is performed.

11. Use of a device according to claim 10, **characterized in that** at least one conduct (13a-13e) ends in the first process chamber (10), by which process gases for generating a reactive medium are lead to the process chamber (10), and that the second process chamber (20) is supplied, via conducts (26a-26c), with precursors as well as via a further conduct (26d) with a carrier gas.

12. Use of a device according to claims 10, **characterized in that** in the first process chamber (10) hydrogen, carbonic acid, hydrocarbon and/or argon as well as oxygen, ozone and/or chlorine is present.

13. Use of a device according to one of the previous claims, **characterized in that** in the second process chamber (20) water, trimethylaluminum or titanium is present, wherein the temperature of the water is approximately 30°C, the one of the trimethylaluminum is approximately 25°C, and the one of the titan chloride is approximately 25°C.

14. Use of a device according to one of the claims 10 to 13, **characterized in that** a control and monitoring unit (30) of the device (1) controls the pressure being present in the process chambers (10, 20) to be approximately 0,15 to 0,50 mbar, preferably 0,25 mbar.

15. Use of a device according to one of the claims 10 to 14, **characterized in that** the second process chamber (20) has a heating unit.

16. Use of a device according to one of the previous claims, **characterized in that** the first process chamber (10) and/or the second process chamber (20) has a vent pipe (18 and 24 respectively).

## Revendications

1. Procédé servant à revêtir une surface de substrat métallique d'une couche de matériau appliquée par un processus ALD, sachant que la surface de substrat métallique à revêtir est soumise, avant l'application de la couche de matériau, à un prétraitement par plasma, **caractérisé en ce qu'**un prétraitement par plasma, à au moins deux phases est utilisé en tant que prétraitement par plasma, sachant que, lors d'une première phase du prétraitement par plasma à au moins deux phases, une réduction de la surface de substrat est effectuée à l'aide d'un, plasma de réduction servant à nettoyer la surface de substrat d'un matériau organique et qu'immédiatement après, lors d'une deuxième phase, une oxydation de la surface de substrat à revêtir est effectuée à l'aide d'un plasma d'oxydation servant à réaliser une couche d'oxyde stable, sur laquelle la couche de matériau à séparer par le processus ALD qui suit peut se rattacher.

2. Procédé selon la revendication 1, **caractérisé en ce qu'**un plasma de carbone, un plasma d'hydrogène, un plasma d'acide carbonique, un plasma d'hydrocarbure ou un plasma d'argon est utilisé en tant qu'agent de réduction.

3. Procédé selon la revendication 1, **caractérisé en ce qu'**un plasma d'oxygène, un plasma d'ozone ou un plasma de chlore est utilisé en tant qu'agent d'oxydation.

4. Procédé selon l'une quelconque des revendications précédentes, **caractérisé en ce que**, après les deux phases du prétraitement par plasma de la surface de substrat métallique à l'aide d'un plasma de réduction et d'un plasma d'oxydation, la surface de substrat métallique est soumise, lors d'une troisième phase du prétraitement par plasma, à l'action d'un plasma d'amplification d'oxydation, en particulier à l'action d'un plasma de chlore.

5. Procédé selon l'une quelconque des revendications précédentes, **caractérisé en ce que** le prétraitement par plasma est effectué lors d'un procédé à basse pression, sachant que de préférence une pression allant de 0,15 à 0,50 mbar, de préférence une pression de 0,25 mbar, est utilisée.

6. Procédé selon l'une quelconque des revendications précédentes, **caractérisé en ce que** le prétraitement par plasma est effectué à température ambiante.

7. Procédé selon l'une quelconque des revendications précédentes, **caractérisé en ce que**, aux fins du revêtement ALD, la surface de substrat est chauffée à une température comprise entre 60° et 120°, de préférence à une température d'environ 100°.

8. Procédé selon l'une quelconque des revendications précédentes, **caractérisé en ce que** le traitement de la surface de substrat métallique est effectué à l'aide du plasma de réduction pendant une durée comprise entre 2,6 et 3,5 min, de préférence pendant une durée d'environ 3 min.

9. Procédé selon l'une quelconque des revendications précédentes, **caractérisé en ce que** le traitement de la surface de substrat métallique est effectué à l'aide du plasma d'oxydation et/ou à l'aide du plasma d'amplification d'oxydation pendant une durée allant de 0,6 à 1,5 min, de préférence pendant une durée d'environ 1 min.

10. Utilisation d'un dispositif servant à revêtir une surface de substrat métallique d'une pièce à usiner d'une couche de matériau appliquée par un processus ALD, sachant que le dispositif présente une première chambre de processus (10) et une deuxième chambre de processus (20), **caractérisée en ce que** la première chambre de processus (10) est réalisée sous la forme d'une chambre à plasma, dans laquelle un prétraitement par plasma à deux phases est effectué, sachant que, dans la première chambre de processus (10), la surface de substrat de la pièce à usiner se trouvant dans celle-ci est soumisse, afin d'être nettoyée d'un matériau organique, à l'action d'un plasma de réduction et, immédiatement auprès, à l'action d'un plasma d'oxydation afin de réaliser une couche d'oxyde, et **en ce que** la deuxième chambre de processus (20) est réalisée sous la forme d'une chambre de processus ALD, dans laquelle un revêtement ALD de la pièce à usiner prétraitée dans la première chambre de processus (10) est effectué.

11. Utilisation d'un dispositif selon la revendication 10, **caractérisée en ce qu'**au moins une conduite (13a - 13e) débouche dans la première chambre de processus (10), par l'intermédiaire de laquelle des gaz de processus servant à produire un agent réactif sont amenés à la première chambre de processus (10), et **en ce que** les précurseurs requis pour le processus ALD sont amenés par l'intermédiaire de conduites (26a - 26c) et un gaz porteur est amené par l'intermédiaire d'une autre conduite (26d) à la deuxième chambre de processus (20).

12. Utilisation d'un dispositif selon la revendication 10, **caractérise en ce que** de l'hydrogène, de l'acide carbonique, un hydrocarbure et/ou de l'argon ainsi que de l'oxygène, de l'ozone et/ou du chlore sont présents dans la première chambre de processus (10).

13. Utilisation d'un dispositif selon l'une quelconque des revendications précédentes, **caractérisée en ce que** de l'eau, du triméthylaluminium ou du titane sont présents dans la deuxième chambre de processus (20), sachant que la température de l'eau est d'environ 30 °C, celle du triméthylaluminium amené d'environ 25 °C et celle du chlorure de titane amené d'environ 25 °C.

14. Utilisation d'un dispositif selon l'une quelconque des revendications 10 à 13, **caractérisée en ce qu'**une unité de régulation et de surveillance (30) du dispositif (1) régule la pression de processus régnant dans les chambres de processus (10, 20) à environ 0,15 à 0,50 mbar, de préférence à 0,25 mbar.

15. Utilisation d'un dispositif selon l'une quelconque des revendications 10 à 14, **caractérisée en ce que** la deuxième chambre de processus (20) présente une système de chauffage.

16. Utilisation d'un dispositif selon l'une quelconque des revendications précédentes, **caractérisée en ce que** la première chambre de processus (10) et/ou la deuxième chambre de processus (20) présentent une conduite d'évacuation d'air (18 ou 24).
